# EUROPEAN PATENT APPLICATION

(11) **EP 4 773 787 A1**
(43) Date of publication of application: **08.07.2026**
(21) Application number: 24857535.9
(22) Date of filing: 29.08.2024
(51) Int. Cl.: H10N 50/85, H01F 10/08, G01Q 60/38, G01Q 60/54

(54) **NANOSTRUCTURE COMPRISING AN ISOLATED SKYRMION, FABRICATION PROCESS THEREFOR AND USE THEREOF IN MICROSCOPY AND SENSING**

(30) Priority: 31.08.2023 BR 102023017710
(71) Applicant: Centro Nacional de Pesquisa em Energia e Materiais - CNPEM, 13083-100 Campinas - SP (BR)
(72) Inventor: DE ALMEIDA MORI, Thiago José, Distrito de Barão Gerlado, Campinas (BR); BETTINI, Jefferson, 13083100 Campinas (BR); ALEXANDRE DUGATO, Danian, 13083100 Campinas (BR)
(74) Representative: Plasseraud IP
(86) International application number: PCT/BR2024/050389
(87) International publication number: WO 2025/043318

(57) **Abstract**

The present disclosure relates to a process for fabricating a nanostructure comprising an isolated skyrmion in which a focused-ion-beam thinning technique is applied to a base material, generating a thinned structure in the form of columns (20), followed by the deposition of thin metallic films onto the columns (20), thereby forming a nanostructure (10) capable of generating a single isolated skyrmion at its top. Also described are the fabricated nanostructures (10) and uses thereof in magnetic microscopy and magnetic sensing.

## Description

### TECHNICAL FIELD

The present disclosure relates to the field of fabrication or processing of nanostructures formed by the individual manipulation of atoms, molecules, or limited groups of atoms or molecules as discrete units. The present disclosure also relates to the field of specific uses or applications of nanostructures for sensing purposes.

### PRIOR ART

The recent discovery of magnetic skyrmions has sparked intense interest in condensed-matter physics and materials science. The particular spin texture of magnetic skyrmions gives rise to a series of unique phenomena due to their topologically protected quantum state and emergent electromagnetic field.

The prior art includes certain fabrication technologies for skyrmion-generating surfaces and their indicated uses, mainly for applications in lowdissipation magnetic information storage devices, but also in magnetic field sensors.

Patent document WO2017024253A1 describes a method for fabricating artificial skyrmions and skyrmion lattices that are stable at room temperature. The method involves depositing one or more layers of material (e.g., alternating layers of Co/Pd, Co/Pt, Co/Ni, or CoFeB/MgO, or single layers of FePt, FePd, CoPt, CoPd, GdFeCo, TbFeCo) onto a substrate with perpendicular magnetic anisotropy by physical vapor deposition (sputtering); forming asymmetric patterns in the material layer so as to expose portions of the substrate; irradiating the exposed substrate with ions; removing the material layer; and finally applying a specific magnetic field sequence to prepare the skyrmion state. The result of the process is a surface capable of generating multiple skyrmions at room temperature, and applications thereof are described in magnetic memory devices, logic devices, and sensors.

Patent document WO2018203554A1 describes a method for fabricating a magnetic device that generates skyrmions at room temperature, wherein the resulting device is capable of generating one to three skyrmions on structures having a substantially triangular shape (with sides between 150 and 800 nm), a circular shape (with a radius of approximately 120 nm), or a square shape (dimensions not specified). The method includes producing a plurality of nanometric dot-shaped defects on a flat magnetic material by exposing that material to an electron beam. The described uses for the resulting device include its application as a magnetic memory capable of storing information, and its application in magnetic sensors for detecting magnetism or magnetic tracks.

In view of the above literature, techniques for fabricating skyrmion-generating nanometric structures and their application as magnetic sensors are known. However, previous techniques are based on flat magnetic substrates and therefore have not overcome the difficulties associated with applications requiring particular geometries, such as, for example, the challenges related to sensing configurations in which a single skyrmion is isolated, such as in a magnetic probe tip of an atomic-force-microscopy (AFM) sensor.

### BRIEF DESCRIPTION

One of the objects of the present disclosure is to provide a process for fabricating a nanostructure that generates a single stable skyrmion, which can be grown on different materials used as substrates, including on a magnetic AFM probe tip, thereby increasing the magnetic resolution of said tip and considerably increasing its lifespan when compared to commercial tips (coated with cobalt film). Another object of the present disclosure is to provide the use of said nanostructure in atomic-force microscopy, with emphasis on magnetic applications, as well as its use as a nanometric sensor in different types of spatial arrangements.

The objects of the present disclosure are achieved by a process comprising the steps of:
thinning a material that will serve as a substrate, preferably the apex material of a magnetic AFM probe tip, using a focused-ion-beam thinning technique (herein referred to as FIB), preferably using a focused Ga-ion FIB, thereby producing, in the thinned material, at least one column in the form of a cylindrical pillar having a diameter on a nanometer scale;
growing on the column of thinned material one or more thin metallic films, preferably by a physical vapor deposition technique, thereby forming a multilayer nanostructure with perpendicular magnetic anisotropy, said nanostructure having an approximately conical shape and being capable of generating a single stable skyrmion at its top.

The objects of the present disclosure are also achieved by the use of the aforementioned nanostructure in microscopy, wherein both the thinning process and the growth process are performed on an AFM probe tip, and the resulting microscopy is magnetic-force microscopy (hereinafter referred to as MFM).

The objects of the present disclosure are also achieved by the use of said nanostructure in magnetic sensing, wherein a plurality of structures is grown on a thinned substrate, preferably a silicon substrate, said structures being arranged at regular distances from one another to form a planar geometric array suited to the intended sensing application, for example, a planar geometric arrangement forming a circle, triangle, rectangle, pentagon, hexagon, or any polygon appropriate for the desired sensing application.

### BRIEF DESCRIPTION OF THE DRAWINGS

The present disclosure is illustrated in the embodiments shown in the figures, which are briefly described below.
Figure 1 is a schematic representation of a column of base material thinned by FIB, comprising a skyrmion-generating nanostructure deposited on its top, according to an embodiment of the present disclosure.
Figure 2A is a schematic representation of metallic layers deposited to form a skyrmion-generating nanostructure, according to an embodiment of the present disclosure.
Figures 2B to 2D are scanning electron microscopy images of three planar geometric arrangements with 9 columns of skyrmion-generating nanostructures, according to an embodiment of the present disclosure, while Figures 2E to 2G are magnetic-force-microscopy images of the nanostructures shown in Figures 2B to 2D, respectively. Figure 2H is a magnified view of a single nanostructure from Figure 2G, showing a single skyrmion centered within its internal diameter, according to an embodiment of the present disclosure.
Figures 3A and 3B are, respectively, a magnetic-force-microscopy image of a structure from the array shown in Figure 2F and a plot of the magnetic amplitude of that single nanostructure as a function of radial position, according to an embodiment of the present disclosure.
Figures 3C and 3D are, respectively, a magnetic-force-microscopy image of a structure from the array shown in Figure 2G and a plot of the magnetic amplitude of that single nanostructure as a function of radial position, according to an embodiment of the present disclosure.
Figure 4A is a scanning electron microscopy image of an AFM tip prior to the thinning step, according to an embodiment of the fabrication process of the present disclosure.
Figures 4B to 4D are scanning electron microscopy images from different angles of an AFM probe tip after the deposition of a cylindrical structure having a diameter of 250 nm at its apex, according to an embodiment of the fabrication process of the present disclosure.
Figures 5A and 5B are two magnetic-force-microscopy images of a hard disk, obtained using an AFM probe tip modified according to an embodiment of the process of the present disclosure and a prior-art AFM probe, respectively.

### DETAILED DESCRIPTION OF THE EMBODIMENTS

The present disclosure relates to a nanostructure capable of generating a single stable skyrmion at its top. The present disclosure also relates to the process for fabricating said nanostructure and its uses in microscopy and sensing.

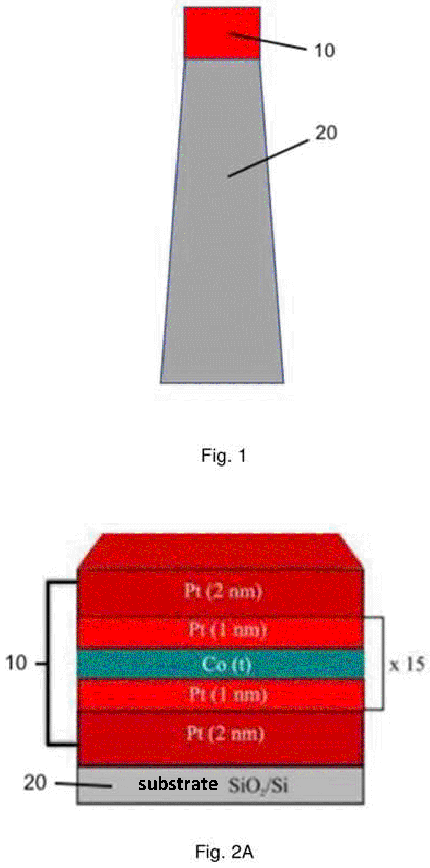

Figure 1 is a schematic representation of the main elements of the single-skyrmion-generating structure, wherein the structure comprises: a column (20) thinned by a FIB technique applied to a base material; and a nanostructure (10) comprising one or more metallic layers grown by thin-film deposition techniques. In the embodiment illustrated in Figure 1, the shape of a thinned column (20) has a variation in cross-section along its length, having a conical section at its base and a cylindrical section at its top. In other embodiments, the column (20) may exhibit uniform cross-sections along its length, as well as cross-sections of other geometries, such as rectangular, triangular, tubular, and any other regular or irregular polygonal shape.

In one embodiment, the fabrication process of said nanostructure comprising a single isolated skyrmion is carried out in two steps, comprising:
(i) thinning a base material using a FIB technique, thereby forming in the thinned material a column having an outer diameter ranging between 150 and 2500 nm;
(ii) growing on the column of thinned material one or more thin metallic films, thereby generating a nanostructure with perpendicular magnetic anisotropy, said nanostructure having a diameter suitable for generating a single stable skyrmion at its top, for example, a diameter between 100 and 400 nm, preferably between 100 and 300 nm.

In one embodiment of the described process, the thinning technique applied to said base material is preferably a focused-ion-beam technique using Ga, Xe, or Ar ions.

In one embodiment of the described process, said base material is the apex of a magnetic AFM probe tip.

In one embodiment of the described process, the base material is a silicon wafer.

Figure 2A is a schematic representation of a nanostructure (10) consisting of multiple thin metallic layers deposited on a base material. In this example, the metallic layers begin and end with thicker Pt layers and include in the middle thereof alternating layers of Pt and Co (represented only once for simplicity, but in this embodiment, repeated alternately 15 times), the alternating layers having a smaller thickness than the initial and final layers.

In one embodiment of the described process, the thin metallic film layers comprise: a first Pt seed layer having a thickness greater than 0.5 nm at the base of the structure; followed by one or more alternating layers of Pt and Co, the first and last alternating layers being Pt; and finally, a Pt capping layer having a thickness greater than 0.5 nm at the top of the nanostructure. The thickness of the remaining layers and the number of layer repetitions may be adjusted to optimize skyrmion generation according to the dimensions of the structure and the intended applications, thereby modifying the magnetic intensity and the linewidth (focusing) of the produced nanostructure.

In one embodiment of the described process, the thin metallic films are arranged in the same order described above, wherein Co is replaced by Ni or Fe, and/or wherein Pt is replaced by Pd, W, Hf, or Ru.

In one embodiment of the described process, the metallic nanostructure is made of a single metal selected from the group comprising: FePt, FePd, CoPt, CoPd, GdFeCo, TbFeCo, CoGd, or any other metals known to a person skilled in the art to support skyrmion formation.

The following are illustrative, non-limiting examples of embodiments of the process and product described herein.

### EXAMPLE 1 - OPTIMIZING THE NANOSTRUCTURE TOP AREA

In order to exemplify the preferred dimensions for implementing the present disclosure, nanostructures (10) and cylindrical columns (20) with various dimensions were tested.

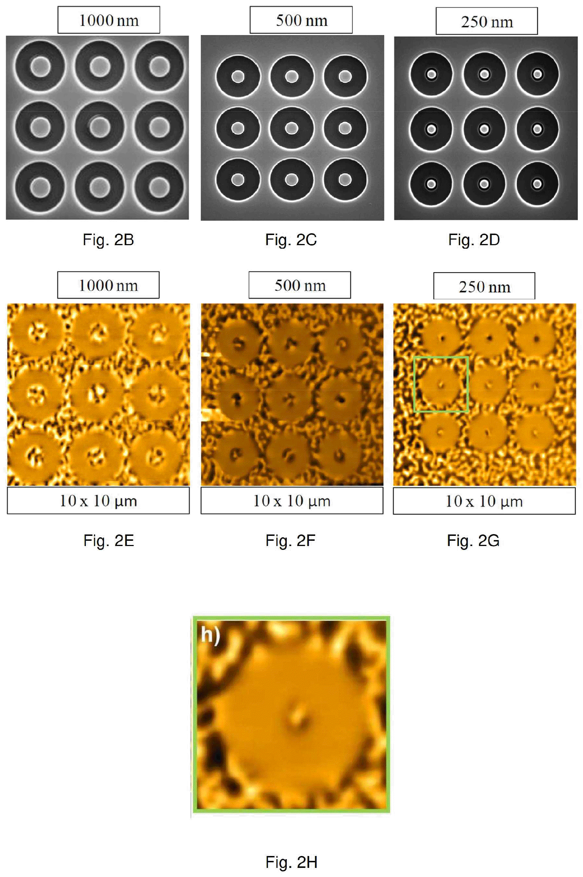

Figures 2B to 2C show scanning electron microscopy images of the cylindrical structures viewed from the top. The structures were prepared by a focused Ga-ion beam thinning technique. The thinning process leaves said cylindrical structure surrounded by a cylindrical trench on the substrate, and Figures 2B to 2D show both the outer diameter of the cylindrical trench and the internal diameter corresponding to the structure itself. In Figure 2B, the internal diameters are 1000 nm and the outer diameters are 3000 nm. In Figure 2C, the internal diameters are 500 nm and the outer diameters are 2500 nm. In turn, in Figure 2D the internal diameters are 250 nm and the outer diameters are 2250 nm. The planar spatial arrangement of the nanostructures in these figures forms a square composed of 9 nanostructures arranged in a 3x3 matrix.

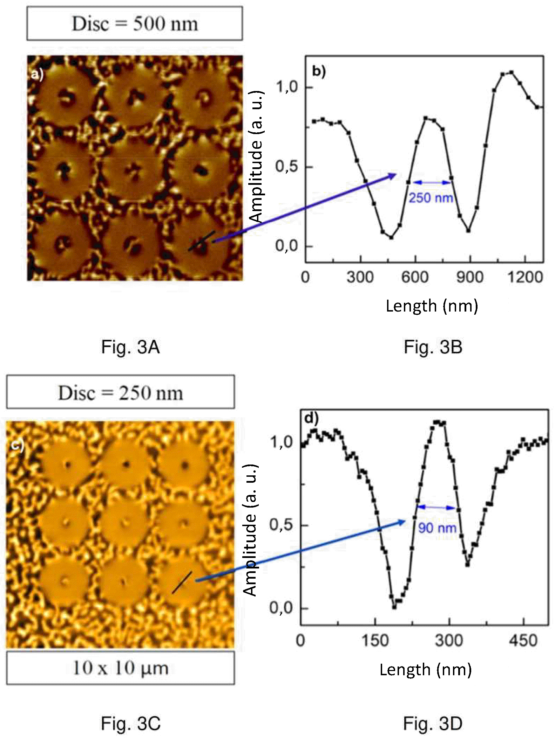

Figures 2E to 2G show the results of magnetic measurements obtained by atomic-force microscopy equipped with a magnetically sensitive probe, known as magnetic-force microscopy (MFM) measurements. Figure 2H is a magnified view of the region marked by the green square in Figure 2G. Typically, each isolated bright circle can be associated with the formation of a skyrmion, which is confirmed through magnetic amplitude and linewidth analysis (shown in the plots of Figure 3, described in the next example).

The image in Figure 2E shows the formation of several skyrmions within a single cylindrical structure and across all cylindrical structures. The image in Figure 2F shows the formation of three isolated skyrmions in three distinct cylindrical structures, whereas two or more skyrmions are formed in the remaining cylindrical structures. Finally, Figure 2G shows the formation of seven isolated skyrmions in distinct structures and two empty structures. Figure 2H shows the presence of the skyrmion, isolated in detail. Thus, it is demonstrated that the process described herein is capable of generating a metallic nanostructure bearing a single isolated skyrmion at its top, the nanostructure having a diameter between 100 nm and 400 nm, preferably between 200 nm and 300 nm, and more preferably around 250 nm.

### EXAMPLE 2 - MAGNETIC AMPLITUDE PROFILE

Figures 3A and 3C show an enlargement of Figures 2F and 2G, with the magnetic-amplitude profiles of one of the isolated skyrmions in the plot on the right, in Figures 3B and 3D. For the cylindrical structures of 250 nm (Fig. 3C), the growth of the skyrmion-generating layer resulted in 7 nanostructures with isolated and centered skyrmions and 2 nanostructures without skyrmions, out of the 9 nanostructures fabricated. The magnetic-amplitude profile of a skyrmion of the 500 nm cylindrical nanostructure is shown in Figure 3B, in which a spatial linewidth of 250 nm stands out, whereas the profile of the skyrmion generated in the 250 nm cylindrical structure (Fig. 3D) shows a linewidth of 90 nm. Thus, it is demonstrated that it is possible to control the linewidth and the magnetic amplitude of skyrmions through the process and product described herein. It should be noted that the smaller the linewidth, the greater the magnetic resolution of the cylindrical structure.

### EXAMPLE 3 - FABRICATION ON AN AFM PROBE TIP

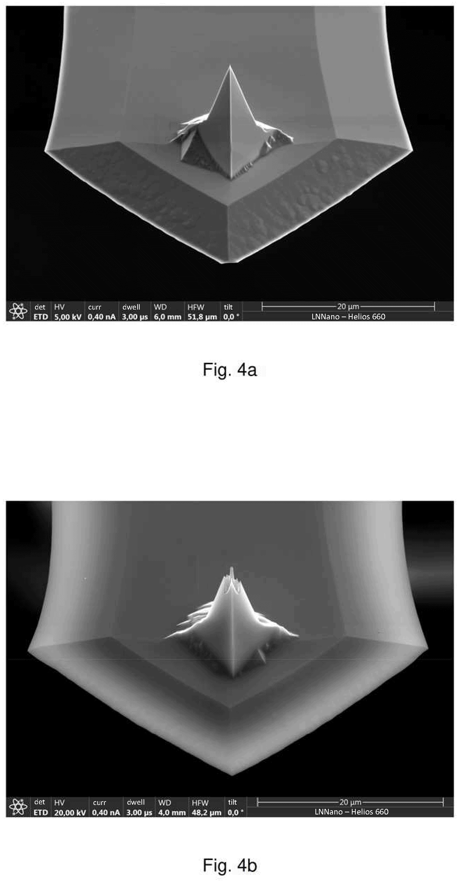

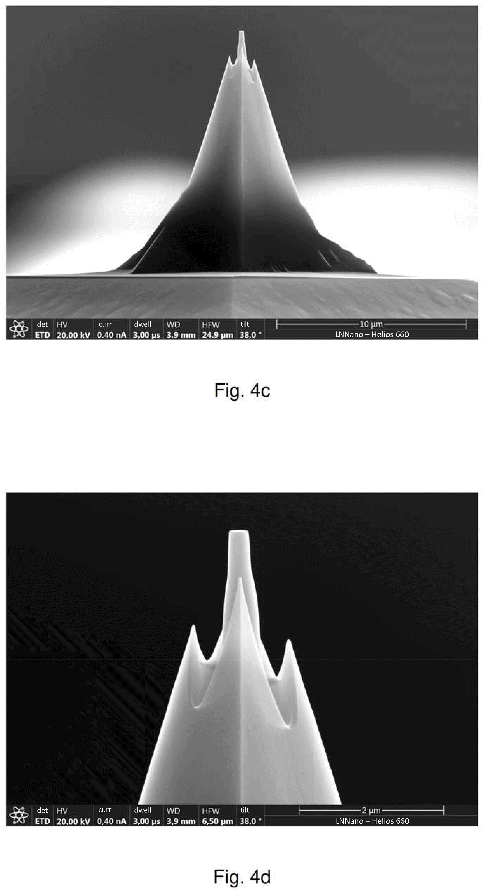

After exemplifying the dimensional optimization of the cylindrical nanostructure for generating isolated skyrmions, cylindrical structures of 250 nm were fabricated on AFM tips, as shown in Figures 4A to 4E. Figure 4A shows a scanning electron microscopy image of an AFM tip. Figure 4B shows the same AFM tip after the fabrication of the cylindrical structure of 250 nm in diameter; again, it is observed that the structure was fabricated using a focused ion beam (FIB). Figure 4C is a side view of the same AFM tip with the fabricated structure, and Figure 4D is a magnified view of the observed tip.

### EXAMPLE 4 - APPLICATION IN MAGNETIC-FORCE MICROSCOPY

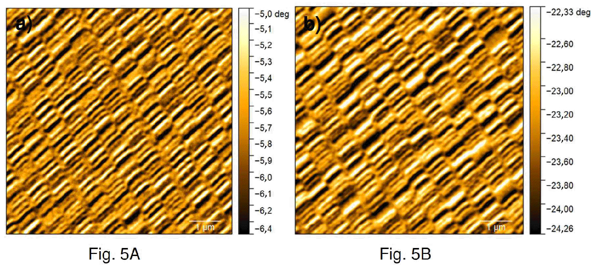

After the fabrication of the cylindrical structures on AFM tips, as in the previous example, skyrmion-generating metallic layers were deposited onto the AFM tips containing the cylindrical structures. The results were tested using a standard sample for magnetic AFM probe testing, taken from a piece of a hard disk. Figures 5A and 5B show the results of magnetic-force-microscopy (MFM) measurements obtained using the two AFM tips: Figure 5A corresponds to a tip containing an isolated skyrmion according to the present disclosure, and Figure 5B corresponds to a commercial tip. It should be noted that the measurement obtained with the AFM tip containing the skyrmion presents an image with greater detail compared to the image generated using the commercial tip. Another important point is that the same measurement performed with the AFM tip containing the skyrmion was carried out again months later, and the image remained consistent. By contrast, a commercial magnetic AFM tip becomes unusable after one day of use or a few scans.

Although exemplary embodiments of the processes and products described herein have been presented in this specification, the scope of protection is not intended to be limited to the literal wording of such embodiments. Accordingly, the description should be interpreted not as limiting, but merely as examples of particular embodiments that maintain unity of invention with the subject matter presented herein. A person skilled in the art may readily apply the teachings presented herein to analogous solutions derived therefrom, limited only by the scope of the claims of the present application.

## Claims

1. A process for fabricating a nanostructure comprising an isolated skyrmion, **characterized in that** it comprises:
(i) thinning a base material using a FIB technique, thereby forming in the thinned material a column (20) having a diameter between 150 and 2500 nm;
(ii) growing on the column (20) of thinned material one or more thin metallic films, thereby generating a nanostructure (10) with perpendicular magnetic anisotropy, said nanostructure having a diameter between 100 and 400 nm, preferably between 200 and 300 nm.

2. The process for fabricating a nanostructure according to claim 1, **characterized in that** the base material is a magnetic AFM probe tip.

3. The process for fabricating a nanostructure according to claim 1, **characterized in that** the base material is a silicon wafer.

4. The process for fabricating a nanostructure according to any of claims 1 to 3, **characterized in that** the thinning technique applied to said base material is preferably FIB using focused ions selected from the group comprising Ga, Xe, and Ar ions.

5. The process for fabricating a nanostructure according to any of claims 1 to 4, **characterized in that** the growth of thin films is carried out by a physical vapor deposition technique.

6. A nanostructure comprising an isolated skyrmion, **characterized in that** it is produced by the process of claims 1 to 5, and **in that** it comprises a nanostructure (10) formed by multiple metallic layers that begin and end with thicker layers of a first metallic material, and include in the middle thereof alternating layers of a first metallic material and a second metallic material, the alternating layers having a thickness smaller than the initial and final layers, wherein at least one of the first and second metallic materials is a magnetic material.

7. The nanostructure according to claim 6, **characterized in that** the thin metallic film layers comprise: an initial layer of the first metallic material having a thickness greater than 0.5 nm; followed by one or more alternating layers of the first metallic material and the second metallic material; and a final layer of the first metallic material having a thickness greater than 0.5 nm, at the top of the nanostructure (10).

8. The nanostructure according to any of claims 6 or 7, **characterized in that** the first metallic material is Pt and the second metallic material is Co.

9. The nanostructure according to any of claims 6 or 7, **characterized in that** the first metallic material is selected from the group comprising Pt, Pd, W, Hf, and Ru, and the second metallic material is selected from the group comprising Co, Fe, and Ni.

10. Use of the nanostructure of claims 6 to 9, **characterized in that** it is for microscopy purposes, wherein both the thinning process and the deposition process are carried out on an AFM probe tip.

11. The use according to claim 10, **characterized in that** it is for performing atomic-force microscopy and magnetic-force microscopy.

12. The use of the nanostructure of claims 6 to 9, **characterized in that** it is for magnetic sensing.

13. The use according to claim 12, **characterized in that** a plurality of nanostructures is provided in a plane, maintaining regular spacing among them, thereby forming a planar geometric arrangement having a shape selected from the group comprising approximately circular shapes and approximately polygonal shapes.
